# FASCICULE DE BREVET EUROPEEN

(11) **EP 3 627 512 B1**
(45) Date de publication et mention de la délivrance du brevet: **16.08.2023**
(21) Numéro de dépôt: 19198432.7
(22) Date de dépôt: 19.09.2019
(51) Int. Cl.: G11C 13/00, H10B 63/00, H10N 70/00, H10N 70/20

(54) **CELLULE À MÉMOIRE RÉSISTIVE**
RESISTIVE SPEICHERZELLE
RESISTIVE MEMORY CELL

(30) Priorité: 21.09.2018 FR 1858602
(43) Date de publication de la demande: 25.03.2020
(73) Titulaire: STMicroelectronics (Rousset) SAS, 13790 Rousset (FR)
(72) Inventeur: BOIVIN, Philippe, 13770 VENELLES (FR)
(74) Mandataire: Cabinet Beaumont

(56) Documents cités:
- WO-A1-2017/222525
- US-A1- 2009 230 378
- US-A1- 2017 317 143
- US-A1- 2018 033 826
- US-A1- 2018 151 623

## Description

### Domaine technique

La présente description concerne de façon générale les dispositifs mémoire et plus précisément les dispositifs à mémoire résistive, par exemple les dispositifs mémoire à changement de phase.

### Technique antérieure

Les mémoires sont généralement sous forme de matrices, comprenant des lignes de mot ("wordline") et des lignes de bit ("bitline"), c'est-à-dire des lignes et des colonnes. Une cellule mémoire, contenant une information binaire, se situe à chaque croisement d'une ligne et d'une colonne.

Dans une mémoire à changement de phase, par exemple, chaque cellule mémoire comprend une couche de matériau à changement de phase qui est en contact avec un élément résistif. Les matériaux à changement de phase sont des matériaux qui peuvent basculer entre une phase cristalline et une phase amorphe. Ce basculement est provoqué par une augmentation de la température de l'élément résistif dans lequel on fait passer un courant électrique. La différence de résistance électrique entre la phase amorphe du matériau et sa phase cristalline est utilisée pour définir au moins deux états de mémoire, arbitrairement 0 et 1.

L'information contenue dans une cellule d'une mémoire à changement de phase est par exemple accédée, ou lue, en mesurant la résistance entre la ligne de bit et la ligne de mot de la cellule mémoire.

Les cellules mémoire sont généralement associées à un élément de sélection, par exemple un transistor de sélection. Lors de l'écriture ou de la lecture d'une cellule, l'élément de sélection permet le passage du courant dans l'élément résistif de cette cellule. L'élément de sélection permet aussi de limiter le courant traversant les autres cellules mémoire (non sélectionnées) et qui pourrait perturber la lecture ou l'écriture de la cellule.

Les éléments de sélection sont généralement formés dans et/ou sur un substrat semiconducteur. Un inconvénient est que les cellules mémoire sont alors limitées en densité et en emplacement par la densité et les emplacements possibles des éléments de sélection dans le substrat.

Le document US-2018-151623 décrit un procédé de fabrication d'un dispositif électronique comprenant une pluralité de cellules mémoire à changement de phase, comprenant successivement:
- la formation d'un premier niveau d'un réseau d'interconnexion de manière à former des pistes conductrices (110);
- la formation d'un empilement de couches formant des sélecteurs sur le premier niveau;
- la formation d'une deuxième couche isolante sur l'empilement de couches;
- la gravure de la deuxième couche isolante de manière à former une deuxième cavité, chaque deuxième cavité traversant la deuxième couche isolante de manière à atteindre l'empilement de couches, chaque deuxième cavité comprenant deux parois parallèle l'une à l'autre;la formation d'une troisième couche en un matériau résistif sur la deuxième couche isolante et sur les parois et le fond de chaque deuxième cavité;
- la formation de premiers espaceurs et d'éléments résistifs, par gravure, au niveau des parois de chaque deuxième cavité recouvrant les parois de chaque deuxième cavité et une partie du fond de ladite deuxième cavité, au pied des parois;
- le remplissage des deuxième cavités par un matériau isolant de manière à former une région isolante dont la face supérieure est coplanaire avec la face supérieure de la deuxième couche isolante;
- la formation d'une couche de matériau à changement de phase et d'une couche conductrice;
- la formation d'un second niveau du réseau d'interconnexion de manière à former des pistes conductrices;
ces étapes permettant l'empilement de couches formant des sélecteurs de ne pas être en contact mécanique avec le matériau à changement de phase.

Le document US-2018-033826 décrit un procédé de fabrication comprenant successivement:
- la formation d'un premier niveau d'un réseau d'interconnexion, de manière à former des pistes conductrices;
- la formation d'un empilement de couches formant des sélecteurs sur le premier niveau;
- la formation d'un élément résistif, d'une couche de matériau à changement de phase et d'une couche conductrice;
- la gravure de tranchées perpendiculaires traversant l'empilement de couches, les éléments résistifs, la couche de matériau à changement de phase, et la couche conductrice de manière à individualiser les différentes cellules mémoire;
- la formation d'un second niveau du réseau d'interconnexion de manière à former des pistes conductrices;
ces étapes permettant l'empilement de couches formant des sélecteurs de ne pas être en contact mécanique avec le matériau à changement de phase.

Les documents US-2017-317143, WO-2017-222525 et US-2009-230378 du domaine des mémoires résistives, décrivent chacun la fabrication conjointe d' éléments mémoire résistifs et de circuits logiques par co-planarité, l'épaisseur de l'élément de sélection jusqu'à l'électrode supérieure correspond à un ou plusieurs niveaux du réseau d'interconnexion de la partie logique.

### Résumé de l'invention

Un mode de réalisation prévoit un procédé de fabrication d'un dispositif électronique comprenant une pluralité de cellules mémoire à changement de phase, le procédé étant décrit par la revendication 1. Ce procédé peut comprendre en outre les limitations apportées par les revendications dépendantes 2 à 7.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente schématiquement un mode de réalisation d'un dispositif mémoire ;
la figure 2 représente schématiquement le résultat d'étapes de fabrication du mode de réalisation de la figure 1 ;
la figure 3 représente schématiquement le résultat d'autres étapes de fabrication du mode de réalisation de la figure 1 ;
la figure 4 représente schématiquement le résultat d'autres étapes de fabrication du mode de réalisation de la figure 1 ;
la figure 5 représente schématiquement le résultat d'autres étapes de fabrication du mode de réalisation de la figure 1 ; et
la figure 6 représente schématiquement un autre mode de réalisation d'un dispositif mémoire.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

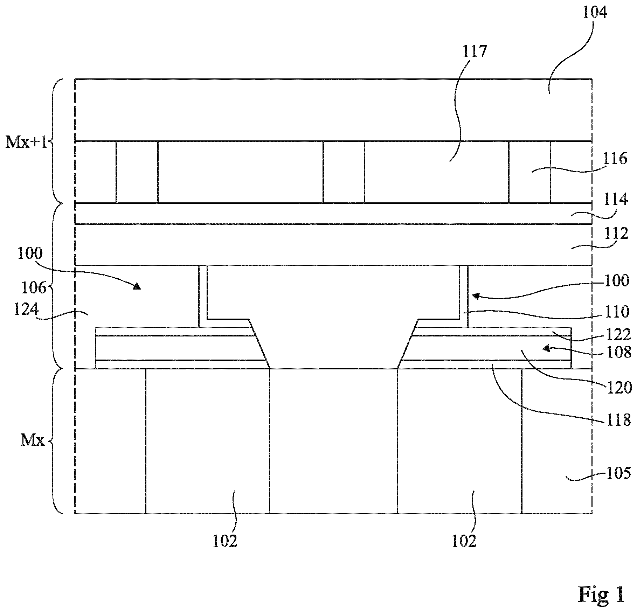

La figure 1 représente schématiquement un mode de réalisation d'un dispositif mémoire.

Le dispositif mémoire comprend une matrice de cellules mémoire 100 situées entre deux niveaux Mx et Mx+1 de pistes conductrices d'un réseau d'interconnexion. Les cellules mémoire ne sont donc pas en contact mécanique avec un substrat et, plus précisément, elles ne comprennent pas d'éléments dans et/ou sur un substrat semiconducteur.

Par niveau Mx et Mx+1 du réseau d'interconnexion, on désigne les niveaux de pistes conductrices numéro x et x+1 à partir d'un substrat, x étant un nombre quelconque.

Chaque niveau Mx et Mx+1 comprend des pistes conductrices (désignées par la référence 102 pour le niveau Mx et par la référence 104 pour le niveau Mx+1) et des vias conducteurs (non représentés pour le niveau Mx et désignés par la référence 116 pour le niveau Mx+1). Les vias conducteurs permettent une connexion électrique avec des éléments conducteurs situés sous le niveau considéré, généralement les pistes conductrices d'un autre niveau du réseau d'interconnexion ou, dans le mode de réalisation décrit, des cellules mémoires. Les pistes conductrices et les vias conducteurs sont entourés par une couche isolante (désignée par la référence 105 pour le niveau Mx et la référence 117 pour le niveau Mx+1).

Dans le mode de réalisation de la figure 1, les cellules mémoire 100 d'une même ligne de la matrice sont interconnectées par une des pistes conductrices 102 du niveau Mx, et les cellules mémoire 100 d'une même colonne de la matrice sont interconnectées par une des pistes conductrices 104 du niveau Mx+1. Il est bien entendu que les interconnexions des lignes et des colonnes pourraient être inversées. Les pistes conductrices 104 (ou 102) interconnectant les colonnes (ou les lignes) sont sensiblement parallèles les unes aux autres.

En figure 1, deux cellules mémoire 100 sont représentées. Ces deux cellules mémoire font partie d'une même colonne de la matrice. Elles sont donc interconnectées par la même piste conductrice 104. Ces deux cellules mémoire font partie de deux lignes adjacentes de la matrice. Ces deux cellules sont donc connectées à des pistes conductrices 102 distinctes.

Chaque cellule mémoire comprend un empilement 106 d'un sélecteur 108, d'un élément résistif 110, d'une couche 112 de matériaux à changement de phase, et d'une couche conductrice 114. La couche 112 de matériau à changement de phase et la couche conductrice 114 sont communes aux cellules mémoire d'une même colonne. Les sélecteurs 108 et les éléments résistifs 110 sont séparés les uns des autres par des régions isolantes 124. Les régions isolantes 124 séparent aussi les couches 112 et 114 des différentes colonnes les unes des autres.

Le sélecteur 108 comprend, de préférence, un empilement de trois couches, une première couche conductrice 118 en contact avec au moins une partie de la piste conductrice 102 correspondante, une deuxième couche 120 en un chalcogénure, par exemple un alliage à base de germanium et de sélénium, et une troisième couche 122 conductrice, permettant d'empêcher la diffusion du matériau de la couche 120. Les couches conductrices 118 et 122 sont par exemple en carbone. La couche conductrice 118 permet de limiter la diffusion du matériau de la couche 105 vers la couche 120.

Le sélecteur 108 comprend deux états : un premier état dans lequel le sélecteur 108 a une résistance suffisamment élevée pour que le courant le traversant soit sensiblement nul, et un deuxième état dans lequel le sélecteur a une résistance suffisamment faible pour laisser passer un courant. Le sélecteur 108 passe du premier état au deuxième état lorsque la tension appliquée entre sa face supérieure et sa face inférieure dépasse un seuil. La valeur du seuil dépend par exemple des caractéristiques de la couche en chalcogénure et est choisie à partir de la valeur de la tension qui sera fournie à la cellule mémoire lors de la lecture ou de l'écriture. Plus précisément, la valeur du seuil est choisie de telle manière que le sélecteur 108 de la cellule mémoire 100 dans laquelle on cherche à lire ou écrire est dans le deuxième état et que les sélecteurs 108 de toutes les autres cellules, recevant à leurs bornes une tension plus faible, sont dans le premier état.

Les sélecteurs sont des composants passifs, c'est-à-dire qu'ils ne reçoivent pas de courant de commande. De plus, ils ne sont pas situés dans le substrat.

Le sélecteur 108 de chaque cellule mémoire est de préférence sensiblement plan. Le sélecteur 108 est en contact électrique et physique avec la piste conductrice 102 connectant les cellules mémoire 100 de la ligne considérée et avec l'élément résistif 110. Le sélecteur 108 n'est pas en contact physique avec la couche de matériau à changement de phase 112. Autrement dit, l'élément résistif est interposé, ou situé entre, le matériau à changement de phase et le sélecteur. Le sélecteur 108 est relié électriquement à cette couche 112 par l'élément résistif 110.

L'élément résistif 110 a par exemple une section en forme de L. La partie horizontale de l'élément résistif 110 repose sur le sélecteur 108. La partie verticale de l'élément résistif 110 s'étend du sélecteur 108 à la couche 112 de matériau à changement de phase. La forme en L de l'élément résistif lui permet d'avoir un large contact avec le sélecteur 108 et un contact fin avec le matériau à changement de phase. La partie supérieure de l'élément résistif est donc plus résistive que la partie inférieure, et la zone de chauffe est donc principalement au niveau de la partie supérieure de l'élément résistif.

La couche conductrice 114 est en contact, par l'intermédiaire de vias conducteurs 116 du niveau Mx+1, à la piste conductrice 104 interconnectant les cellules mémoire de la colonne considérée.

La distance entre la face inférieure du sélecteur et la face supérieure de la couche conductrice 114 est sensiblement égale à un multiple de l'épaisseur d'un niveau du réseau d'interconnexion. Ainsi, les niveaux Mx et Mx+1 ne sont pas des niveaux successifs. Par exemple, si la distance entre la face inférieure du sélecteur et la face supérieure de la couche conductrice 114 est sensiblement égale à deux fois l'épaisseur d'un niveau du réseau d'interconnexion, les niveaux désignés en figure 1 par les références Mx et Mx+1 peuvent être des niveaux Mx et Mx+2. Un avantage est que les régions du réseau d'interconnexion comprenant des mémoires et les parties n'en comprenant pas ont des niveaux coplanaires.

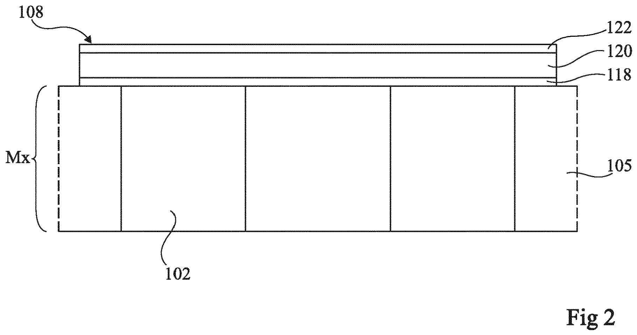

Les figures 2 à 5 illustrent des étapes successives de fabrication du mode de réalisation de la figure 1.

La figure 2 représente schématiquement le résultat d'étapes de fabrication du mode de réalisation de la figure 1 au cours desquelles le niveau Mx du réseau d'interconnexion est formé. Cela comprend la formation d'une couche isolante 105 dans laquelle sont gravées des cavités qui sont ensuite remplies de matériau conducteur de manière à former les pistes conductrices 102. De préférence, des couples de deux pistes conductrices 102 adjacentes, parallèles l'une à l'autre, ont été formées. Un seul couple de pistes conductrices 102 est représenté en figure 1. Chacune de ces pistes conductrices est destinée à interconnecter une ligne de cellules mémoire de la matrice mémoire.

Une couche de sélecteurs 108, c'est-à-dire un empilement des couches formant les sélecteurs 108, est ensuite formée sur le niveau Mx. Par exemple, la couche conductrice 118, la couche 120 en un chalcogénure et la couche conductrice 122 sont formées sur le niveau Mx.

Les couches conductrices 118 et 122 ont par exemple une épaisseur comprise entre environ 1 et environ 5 nm. La couche 120 a par exemple une épaisseur comprise entre environ 7 et 50 nm, par exemple 10 nm.

La couche de sélecteurs 108 est ensuite gravée de manière à former des bandes dont la direction principale, définie par la plus grande dimension, est parallèle à la direction principale des pistes conductrices 102. Plus précisément, chaque bande s'étend entre deux pistes conductrices 102 parallèles. Chaque bande recouvre au moins partiellement les deux pistes conductrices 102 et recouvre la partie de la couche isolante 105 située entre les deux pistes conductrices 102 considérées. Une unique bande est représentée en figure 2.

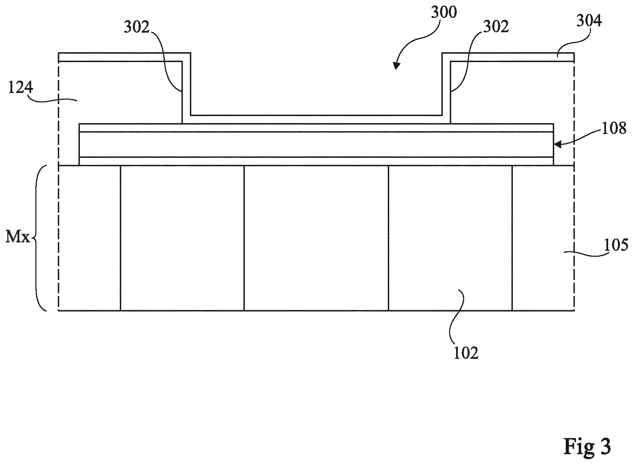

La figure 3 représente schématiquement le résultat d'autres étapes de fabrication du mode de réalisation de la figure 1.

Au cours de ces étapes, une couche isolante, qui formera les régions isolantes 124, est formée sur la couche de sélecteurs 108 et sur les portions du niveau Mx qui ne sont pas recouvertes par la couche de sélecteurs 108. L'épaisseur de cette couche isolante est sensiblement égale à la distance souhaitée entre un sélecteur et la couche de matériau à changement de phase d'une cellule mémoire 100, c'est-à-dire la hauteur de l'élément résistif. Cette couche isolante est ensuite gravée de manière à former une cavité 300 en regard de chaque bande de la couche de sélecteurs 108. Une unique cavité 300 est représentée en figure 3. Chaque cavité 300 traverse la couche isolante de manière à atteindre la couche de sélecteurs 108. Chaque cavité 300 comprend deux parois 302 parallèles l'une à l'autre, chaque paroi 302 étant située en regard d'une des pistes conductrices 102. Les parois 302 ont donc une direction principale, c'est-à-dire définie par la plus grande dimension de la paroi, parallèle à la direction principale de la piste conductrice 102 associée.

Une couche 304 en un matériau résistif est ensuite formée sur la couche isolante 124 et sur les parois et le fond des cavités 300. La couche 304 a par exemple une épaisseur comprise entre environ 3 et environ 8 nm.

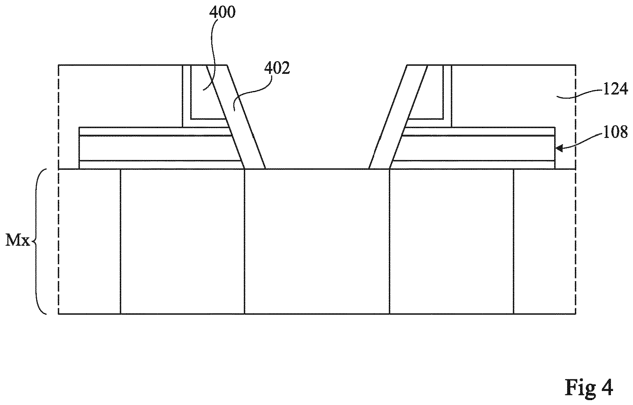

La figure 4 représente schématiquement le résultat d'autres étapes de fabrication du mode de réalisation de la figure 1.

Au cours de ces étapes, des espaceurs 400 sont formés au niveau des parois de chaque cavité 300, recouvrant les parois et une partie du fond de la cavité au pied des parois. Lors de la gravure des espaceurs 400, les parties de la couche 304 de matériau résistif n'étant pas recouvertes par les espaceurs 400 sont retirés, formant ainsi les éléments résistifs 110 en forme de L. La gravure est maintenue dans le fond des cavités 300 jusqu'à atteindre le niveau Mx.

Chaque bande de la couche de sélecteurs 108 est divisée en deux bandes, chacune étant au moins partiellement en regard d'une des pistes conductrices 102 et s'étendant dans une direction principale parallèle à la direction principale de la piste conductrice 102.

Des deuxièmes espaceurs 402 sont formés sur les premiers espaceurs et sur les parois de la couche de sélecteurs 108 découvertes lors de l'étape de gravure précédemment décrite.

La face supérieure de la partie verticale de chaque élément résistif 110 reste découverte et est sensiblement coplanaire avec les faces supérieures des régions isolantes 124.

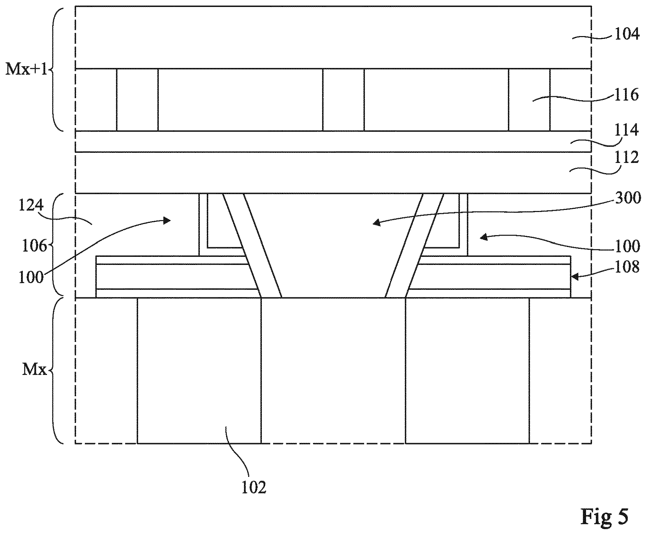

La figure 5 représente schématiquement le résultat d'autres étapes de fabrication du mode de réalisation de la figure 1.

Au cours de ces étapes, chaque cavité 300 est remplie de matériau isolant de manière à former une région isolante 124 dont la face supérieure est coplanaire avec la face supérieure des autres régions 124.

La couche 112 de matériau à changement de phase et la couche conductrice 114 sont formées sur l'ensemble de la structure obtenue après le remplissage de la cavité 300.

Des tranchées non représentées s'étendant à travers l'empilement 106, c'est-à-dire de la couche conductrice 114 à la face supérieure du niveau Mx, sont ensuite gravées. Ces tranchées, situées dans des plans parallèles au plan de coupe de la figure 5, individualisent les différentes cellules mémoire des lignes de la matrice. Ainsi, chaque ligne comprend une pluralité de cellules mémoire séparées par les tranchées non représentées. Ces tranchées sont ensuite remplies d'un matériau isolant de manière à former des régions isolantes 124.

Une étape de formation du niveau Mx+1 est ensuite effectuée. Cette étape comprend la formation d'une ou plusieurs couches isolantes dans lesquelles des cavités ayant la forme des vias conducteurs 116 et des pistes conductrices 104 sont gravées. Ces cavités sont remplies de matériau conducteur.

A titre de variante non couverte par les revendications, l'étape de gravure permettant l'individualisation des cellules mémoire de chaque ligne peut être effectuée avant la formation des couches 112 et 114. Les couches 112 et 114 sont alors formées et gravées postérieurement. Il est alors possible de former des éléments résistifs de largeur différente, par exemple inférieure, à la largeur de la bande de matériau à changement de phase.

On aurait pu choisir de former la couche de sélecteurs 108 après la formation de la cavité 300. Chaque sélecteur 108 aurait alors une forme sensiblement en L et serait situé entre l'élément résistif 110 et les parois de la cavité 300. Cependant, il y aurait alors un contact mécanique entre la face supérieure de la partie verticale du sélecteur 108 et la couche de matériau à changement de phase 112. Un courant de fuite pourrait alors passer du sélecteur à la couche de matériau à changement de phase sans traverser l'élément résistif, ce qui entraînerait une perte d'énergie. De plus, la hausse de température, lors d'une opération de lecture ou d'écriture de la cellule, entrainerait de l'interdiffusion entre les matériaux de la couche de matériau à changement de phase 112 et le sélecteur 108, et donc une modification de la composition de la couche 112.

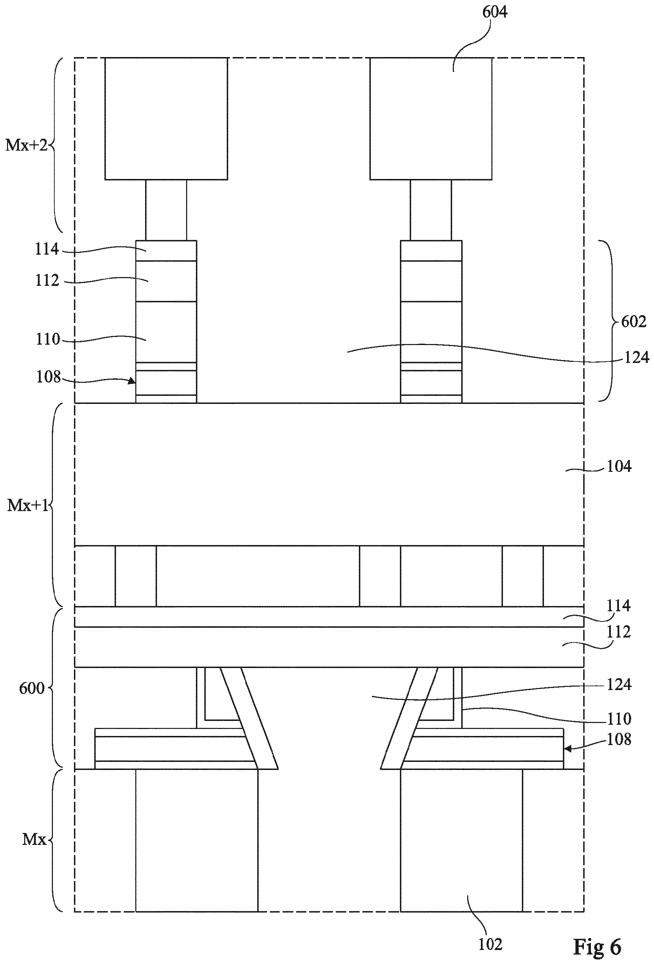

La figure 6 représente schématiquement un autre mode de réalisation d'un dispositif mémoire.

Le dispositif mémoire comprend des première et deuxième matrices mémoire 600 et 602 similaires à la matrice mémoire décrite en relation avec la figure 1. La première matrice mémoire 600 est située entre des niveaux Mx et Mx+1 d'un réseau d'interconnexion et la deuxième matrice mémoire 602 est située entre les niveaux Mx+1 et Mx+2 du réseau d'interconnexion.

Chaque piste conductrice 102 du niveau Mx interconnecte les cellules d'une même ligne de la matrice 600. Chaque piste conductrice 104 du niveau Mx+1 interconnecte les cellules d'une même colonne de la matrice 600 et interconnecte les cellules mémoire d'une même ligne de la matrice 602. Chaque piste conductrice 604 du niveau Mx+2 interconnecte les cellules mémoire d'une même colonne de la matrice 602. Ainsi, la matrice 602 est tournée de 90° par rapport à la matrice 600.

De manière plus générale, un mode de réalisation d'un dispositif mémoire peut avoir un nombre quelconque de matrices mémoire, comprenant chacune un ensemble de cellules mémoire, chaque matrice étant située entre deux niveaux de pistes conductrices du réseau d'interconnexion. Les matrices mémoire peuvent être séparées de plus d'un niveau de pistes conductrices consécutives.

A titre de variante, le nombre et la densité de cellules mémoire peut varier d'une matrice à une autre.

A titre de variante non-couverte par les revendications, les modes de réalisation décrits sont aussi applicables à des cellules mémoire résistives autres que les cellules mémoire à changement de phase.

Un avantage des modes de réalisation décrits est qu'il est possible d'augmenter le nombre de cellules mémoire sans augmenter la surface en vue de dessus, et donc la surface de substrat.

Un autre avantage des modes de réalisation décrits est qu'ils permettent de libérer de l'espace dans le substrat pour y placer d'autres composants.

Un autre avantage des modes de réalisation décrits est que les matériaux du sélecteur ne risquent pas de se diffuser dans le matériau à changement de phase et ne risquent donc pas de le détériorer.

Divers modes de réalisation et variantes ont été décrits. L'homme de l'art comprendra que certaines caractéristiques de ces divers modes de réalisation et variantes pourraient être combinées.

Enfin, la mise en oeuvre pratique des modes de réalisation et variantes décrits est à la portée de l'homme du métier à partir des indications fonctionnelles données ci-dessus.

## Revendications

1. Procédé de fabrication d'un dispositif électronique comprenant une pluralité de cellules mémoire à changement de phase, comprenant successivement:
- la formation d'un premier niveau (Mx) d'un réseau d'interconnexion, comprenant la formation d'une première couche isolante (105) dans laquelle sont gravées des premières cavités qui sont ensuite remplies d'un matériau conducteur de manière à former des pistes conductrices (102) ;
- la formation d'un empilement de couches (108) formant des sélecteurs sur le premier niveau (Mx) ;
- la gravure de l'empilement de couches (108) de manière à former des premières bandes dont la direction principale, définie par la plus grande dimension, est parallèle à la direction principale des pistes conductrices (102), chaque première bande s'étendant entre deux pistes conductrices parallèles adjacentes correspondantes et recouvrant au moins partiellement lesdites deux pistes conductrices correspondantes ;
- la formation d'une deuxième couche isolante (124) sur l'empilement de couches et sur les portions du premier niveau qui ne sont pas recouvertes par l'empilement de couches ;
- la gravure de la deuxième couche isolante (124) de manière à former une deuxième cavité (300) en regard de chaque première bande, chaque deuxième cavité traversant la deuxième couche isolante de manière à atteindre l'empilement de couches, chaque deuxième cavité comprenant deux parois (302) parallèle l'une à l'autre, chaque paroi étant située en regard d'une des pistes conductrices correspondantes ;
- la formation d'une troisième couche (304) en un matériau résistif sur la deuxième couche isolantes (124) et sur les parois et le fond de chaque deuxième cavité ;
- la formation de premiers espaceurs (400) et d'éléments résistifs (110), par gravure, au niveau des parois de chaque deuxième cavité (300) recouvrant les parois de chaque deuxième cavité et une partie du fond de ladite deuxième cavité (300), au pied des parois, la gravure étant maintenue dans le fond des deuxième cavités (300) jusqu'à atteindre ledit premier
niveau (MX) du réseau d'interconnexion de manière à
diviser chaque première bande en deux deuxièmes bandes, chaque deuxième bande étant au moins partiellement en regard d'une des pistes conductrices (102) correspondante et s'étendant dans une direction principale parallèle à la direction principale de la piste conductrice correspondante ;
- la formation de deuxièmes espaceurs (402) sur les premiers espaceurs et sur les parois de l'empilement de couches (108) découvertes lors de la gravure des premiers espaceurs, la face supérieure d'une partie verticale de chaque élément résistif (110) restant découverte et sensiblement coplanaire avec les faces supérieures de la deuxième couche isolante (124) ;
- le remplissage des deuxième cavités par un matériau isolant de manière à former une région isolante dont la face supérieure est coplanaire avec la face supérieure de la deuxième couche isolante (124) ;
- la formation d'une couche (112) de matériau à changement de phase et d'une couche conductrice (114) sur l'ensemble de la structure obtenue après le remplissage des deuxièmes cavités ;
- la gravure de tranchées traversant l'empilement de couches (108), les éléments résistifs (110), la couche (112) de matériau à changement de phase, et la couche conductrice (114) de manière à individualiser les différentes cellules mémoire ; et
- la formation d'un second niveau du réseau d'interconnexion, comprenant la formation d'une troisième couche isolante dans laquelle sont gravées des troisièmes cavités qui sont ensuite remplies d'un matériau conducteur de manière à former des vias conducteurs (116) et des pistes conductrices (104),
ces étapes permettant à l'empilement de couches formant des sélecteurs de ne pas être en contact mécanique avec le matériau à changement de phase ; et
ces étapes comprenant en outre la formation d'au moins un troisième niveau du réseau d'interconnexion dans les régions du réseau d'interconnexion ne comprenant pas les différentes cellules mémoire, les étapes ci-dessus étant telles que la distance entre la face inférieure de l'empilement de couches formant des sélecteurs (108) et la face supérieure de la couche conductrice (114) reposant sur la couche de matériau à changement de phase (112) est sensiblement égale à un multiple de l'épaisseur d'un niveau du réseau d'interconnexion de telle manière que les régions du réseau d'interconnexion comprenant les différentes cellules mémoire et les régions du réseau d'interconnexion n'en comprenant pas ont des niveaux coplanaires.

2. Procédé selon la revendication 1, dans lequel chaque élément résistif (110) a une section sensiblement en forme de L.

3. Procédé selon l'une quelconque des revendications 1 à 2, dans lequel chaque sélecteur (108) a une forme sensiblement plane.

4. Procédé selon l'une quelconque des revendications 1 à 3, dans lequel chaque sélecteur (108) comprend un empilement de couches (118, 120, 122), les couches inférieure (118) et supérieure (122) de l'empilement étant des couches conductrices.

5. Procédé selon la revendication 4, dans lequel les couches conductrices (118, 122) sont en carbone.

6. Procédé selon la revendication 4 ou 5, dans lequel chaque sélecteur (108) comprend une couche (120) en un alliage à base de germanium et de sélénium.

7. Procédé selon l'une quelconque des revendications 1 à 6, comprenant au moins deux ensembles de cellules mémoire (100), chaque ensemble étant situé entre deux niveaux (Mx, Mx+1, Mx+2) du réseau d'interconnexion.

## Patentansprüche

1. Verfahren zur Herstellung eines elektronischen Bauelements mit einer Vielzahl von Phasenwechsel-Speicherzellen, das nacheinander Folgendes aufweist:
- Ausbilden einer ersten Ebene (Mx) eines Verbindungsnetzes, das das Ausbilden einer ersten Isolierschicht (105) aufweist, in die erste Hohlräume geätzt werden, die dann mit einem leitenden Material gefüllt werden, um Leiterbahnen (102) zu bilden;
- Ausbilden eines Stapels von Schichten (108), die Selektoren auf der ersten Ebene (Mx) bilden;
- Ätzen des Stapels von Schichten (108), um erste Streifen zu bilden, deren Hauptrichtung, die durch die größte Größe definiert wird, parallel zur Hauptrichtung der Leiterbahnen (102) ist, wobei sich jeder erste Streifen zwischen zwei entsprechenden benachbarten parallelen Leiterbahnen erstreckt und die entsprechenden zwei Leiterbahnen zumindest teilweise bedeckt;
- Ausbilden einer zweiten Isolierschicht (124) auf dem Stapel von Schichten und auf den Abschnitten der ersten Ebene, die nicht von dem Stapel von Schichten überdeckt sind;
- Ätzen der zweiten Isolierschicht (124), um einen zweiten Hohlraum (300) in Bezug auf jeden ersten Streifen zu bilden, wobei jeder zweite Hohlraum die zweite Isolierschicht durchquert, um den Schichtstapel zu erreichen, wobei jeder zweite Hohlraum zwei zueinander parallele Wände (302) aufweist, wobei jede Wand in Bezug auf eine der entsprechenden Leiterbahnen angeordnet ist;
- Ausbilden einer dritten Schicht (304) aus einem Widerstandsmaterial auf der zweiten Isolierschicht (124) und auf den Wänden und dem Boden jedes zweiten Hohlraums;
- Ausbilden von ersten Abstandshaltern (400) und Widerstandselementen (110) durch Ätzen an den Wänden jedes zweiten Hohlraums (300), die die Wände jedes zweiten Hohlraums und einen Teil des Bodens des zweiten Hohlraums (300) an der Basis der Wände bedecken, wobei das Ätzen am Boden der zweiten Hohlräume (300) bis zum Erreichen des ersten Niveaus (Mx) des Verbindungsnetzes fortgesetzt wird, um jeden ersten Streifen in zwei zweite Streifen zu unterteilen, wobei jeder zweite Streifen mindestens teilweise in Bezug auf eine entsprechende der Leiterbahnen (102) angeordnet ist und sich in einer Hauptrichtung parallel zur Hauptrichtung der entsprechenden Leiterbahn erstreckt;
- Ausbilden von zweiten Abstandshaltern (402) auf den ersten Abstandshaltern und auf den Wänden des Stapels von Schichten (108), die während des Ätzens der ersten Abstandshalter freigelegt wurden, wobei die obere Fläche eines vertikalen Teils jedes Widerstandselements (110) unbedeckt und im Wesentlichen koplanar mit den oberen Flächen der zweiten Isolierschicht (124) bleibt;
- Füllen der zweiten Hohlräume mit einem isolierenden Material, um einen isolierenden Bereich zu bilden, dessen obere Fläche koplanar mit der oberen Fläche der zweiten isolierenden Schicht (124) ist;
- Ausbilden einer Schicht (112) aus einem Phasenänderungsmaterials (112) und einer leitenden Schicht (114) auf der gesamten Struktur, die nach dem Füllen der zweiten Hohlräume erhalten wurde;
- Ätzen von Gräben, die durch den Stapel von Schichten (108), die Widerstandselemente (110), die Schicht (112) aus Phasenänderungsmaterial und die leitende Schicht (114) verlaufen, um die verschiedenen Speicherzellen zu individualisieren; und
- Ausbilden einer zweiten Ebene des Verbindungsnetzes, die das Ausbilden einer dritten isolierenden Schicht aufweist, in die dritte Hohlräume geätzt werden, die dann mit einem leitenden Material gefüllt werden, um leitende Vias (116) und Leiterbahnen (104) zu bilden,
diese Schritte ermöglichen es, dass der Schichtstapel, der die Selektoren bildet, nicht in mechanischem Kontakt mit dem Phasenwechselmaterial steht; und
diese Schritte weisen ferner das Ausbilden mindestens einer dritten Ebene des Verbindungsnetzes in den Bereichen des Verbindungsnetzes auf, die nicht die verschiedenen Speicherzellen aufweisen, wobei die obigen Schritte derart sind, dass der Abstand zwischen der Unterseite des Stapels von Schichten, die die Selektoren (108) bilden, und der Oberseite der leitenden Schicht (114), die über der Schicht aus Phasenänderungsmaterial (112) liegt, im Wesentlichen gleich einem Vielfachen der Dicke einer Ebene des Verbindungsnetzes ist, so dass die Bereiche des Verbindungsnetzes, die die verschiedenen Speicherzellen aufweisen, und die Bereiche, die keine Zelle aufweisen, koplanare Ebenen haben.

2. Verfahren nach Anspruch 1, wobei jedes Widerstandselement (110) einen im Wesentlichen L-förmigen Querschnitt aufweist.

3. Verfahren nach einem der Ansprüche 1 bis 2, wobei jeder Selektor (108) eine im Wesentlichen ebene Form aufweist.

4. Verfahren nach einem der Ansprüche 1 bis 3, wobei jeder Selektor (108) einen Stapel von Schichten (118, 120, 122) aufweist, wobei die unteren (118) und oberen (122) Schichten des Stapels leitende Schichten sind.

5. Verfahren nach Anspruch 4, wobei die leitenden Schichten (118, 122) aus Kohlenstoff bestehen.

6. Verfahren nach Anspruch 4 oder 5, wobei jeder Selektor (108) eine Schicht (120) aus einer Legierung auf Basis von Germanium und Selen aufweist.

7. Verfahren nach einem der Ansprüche 1 bis 6, aufweisend mindestens zwei Sätze von Speicherzellen (100), wobei jeder Satz zwischen zwei Ebenen (Mx, Mx+1, Mx+2) des Verbindungsnetzwerks angeordnet ist.

## Claims

1. Method of manufacturing an electronic device comprising a plurality of phase-change memory cells, comprising in sequence:
- forming a first level (Mx) of an interconnect network, comprising forming a first insulating layer (105) in which first cavities are etched, then filled with a conductive material so as to form conductive tracks (102);
- forming a stack of layers (108) constituting selectors on the first level (Mx);
- etching the stack of layers (108) so as to form first strips the main direction of which, as defined by the largest size, is parallel to the main direction of the conductive tracks (102), each first strip extending between corresponding two adjacent parallel conductive tracks and covering at least partly said corresponding two conductive tracks;
- forming a second insulating layer (124) on the stack of layers and on the portions of the first level that are not overlaid by the stack of layers;
- etching the second insulating layer (124) so as to form a second cavity (300) in regard of each first strip, each second cavity passing through the second insulating layer so as to reach the stack of layers, each second cavity comprising two walls (302) parallel to each other, each wall being disposed in regard of one of the corresponding conductive tracks;
- forming a third layer (304) made of a resistive material on the second insulating layer (124) and on the walls and the bottom of each second cavity;
- forming first spacers (400) and resistive elements (110), by etching, at the walls of each second cavity (300) covering the walls of each second cavity and a part of the bottom of said second cavity (300), at the base of the walls, the etching being continued in the bottom of the second cavities (300) until reaching the said first level (Mx) of the interconnect network so as to divide each first strip into two second strips, each second strip being at least partly in regard of one corresponding of the conductive tracks (102) and extending in a main direction of parallel to the main direction of the corresponding conductive track;
- forming second spacers (402) on the first spacers and on the walls of the stack of layers (108) uncovered during the etching of the first spacers, the upper face of a vertical part of each resistive element (110) remaining uncovered and sensibly coplanar with the upper faces of the second insulating layer (124);
- filling the second cavities with an insulating material so as to form an insulating area the upper face of which is coplanar with the upper face of the second insulating layer (124) ;
- forming a layer (112) of phase-change material (112) and a conductive layer (114) on the whole structure obtained subsequent to filling the second cavities;
- etching trenches passing through the stack of layers (108), the resistive elements (110), the layer (112) of phase-change material, and the conductive layer (114) so as to individualise the different memory cells; and
- forming a second level of the interconnect network, comprising forming a third insulating layer in which third cavities are etched, then filled with a conductive material so as to form conductive vias (116) and conductive tracks (104),
these steps allowing the stack of layers constituting selectors not to be mechanically contacting the phase-change material; and
these steps further comprising forming at least one third level of the interconnect network in the areas of the interconnect network non-comprising the different memory cells, the above steps being such that the distance between the lower face of the stack of layers constituting the selectors (108) and the upper face of the conductive layer (114) laying over the layer of phase-change material (112) is about equal to a multiple of the thickness of a level of the interconnect network so as the areas of the interconnect network comprising the different memory cells and the areas comprising no cell have coplanar levels.

2. Method according to claim 1, wherein each resistive element (110) has a substantially L-shaped section.

3. Method according to any of claims 1 to 2, wherein each selector (108) has a substantially planar shape.

4. Method according to any of claims 1 to 3, wherein each selector (108) comprises a stack of layers (118, 120, 122), the lower (118) and upper (122) layers of the stack being conductive layers.

5. Method according to claim 4, wherein the conductive layers (118, 122) are made of carbon.

6. Method according to claim 4 or 5, wherein each selector (108) comprises a layer (120) made of an alloy based on germanium and selenium.

7. Method according to any of claims 1 to 6, comprising at least two sets of memory cells (100), each set being located between two levels (Mx, Mx+1, Mx+2) of the interconnect network.
